# EUROPEAN PATENT SPECIFICATION

(11) **EP 3 008 821 B1**
(45) Date of publication and mention of the grant of the patent: **31.05.2017**
(21) Application number: 13732389.5
(22) Date of filing: 13.06.2013
(51) Int. Cl.: H03G 1/00, H03G 3/30

(54) **ATTENUATOR CONTROL FOR A SIGNAL PROCESSING CHAIN**
DÄMPFUNGSSTEUERUNG FÜR EINE SIGNALVERARBEITUNGSKETTE
COMMANDE D'ATTÉNUATEUR DE CHAÎNE DE TRAITEMENT DE SIGNAUX

(43) Date of publication of application: 20.04.2016
(73) Proprietor: Telefonaktiebolaget LM Ericsson (publ), 164 83 Stockholm (SE)
(72) Inventor: SUNDSTRÖM, Lars, 247 91 Södra Sandby (SE); MATTISSON, Sven, 237 36 Bjärred (SE); STRANDBERG, Roland, 244 65 Furulund (SE); MASTANTUONO, Daniele, 226 49 Lund (SE)
(74) Representative: Ericsson
(86) International application number: PCT/EP2013/062227
(87) International publication number: WO 2014/198314

(56) References cited:
- EP-A1- 1 523 094
- US-A- 5 953 690
- US-A- 6 072 998
- US-A1- 2012 329 417

## Description

### Technical Field

The present invention relates to the field of signal attenuation control.

### Background

A typical radio receiver may comprise one or more antennas operatively connected to a programmable attenuator followed by other components of a receiver chain. That the antenna(s) are operatively connected to the programmable attenuator means that there may or may not be other components (e.g. filters, amplifiers, etc.) between the antenna(s) and the programmable attenuator. The other components may, for example, include an amplifier such as, e.g., a low-noise amplifier (LNA). In the following, the example of the programmable attenuator followed by an LNA will be used for illustrative purposes.

It should be noted that a receiver as referred to herein may comprise a single receiver chain or a system of receiver chains, for example, a plurality of receiver chains on a single chip.

The typical radio receiver may also comprise an automatic gain control (AGC) function that controls at least the attenuator to regulate the overall gain of the receiver chain, e.g. to condition the received signal such that the desired part of the signal is sufficiently lifted above the noise floor and/or to condition the received signal such that high signal levels (causing, for example, clipping and/or other non-linearities) are avoided.

The performance of the LNA and/or other components of the receiver is typically degraded for increased input signal (e.g. voltage) levels, and if the excess signal level (and its duration) is large enough the LNA typically breaks down. In some implementations, the performance of the attenuator itself may also degrade as a function of an excess input signal (e.g. voltage) level and its duration. The degradation may typically be different for different attenuation parameter setting configurations. Generally, performance degradation of a signal processing unit may be due to that a component of the receiver chain is pushed outside the working region where its operations are specified (parameter drift). Parameter drift and ultimately breakdown of a unit may be caused by various wearout processes in the unit such as, for example, dielectric breakdown of gate oxide and hot-carrier injection leading to interface states and traps. This will typically severally reduce the lifetime of the product comprising the receiver chain.

This is particularly prominent in CMOS technology implementations. The evolution of CMOS technology provides improved performance in many regards. However, high stress conditions experienced by CMOS devices lead to parameter drift and ultimately complete breakdown, where the breakdown voltage is typically decreased in CMOS technology implementations compared with other technology implementations. Decreased breakdown voltage reduces the maximum allowed supply voltage and the maximum allowed signal voltage swing. A description of CMOS implementation wearout may be found in A. W. Strong et al., "Reliability Wearout Mechanisms in Advanced CMOS Technologies", Wiley, IEEE, 2009.

An example of an attenuator control method of a signal processing chain is disclosed in US6072998, where a radio receiver having high reception sensitivity is shown. The decreased breakdown voltage of CMOS technology is not necessarily a problem within an integrated circuit implemented with CMOS technology if signal handling may be performed in the current domain in stead of in the voltage domain. However, the interfaces of such a circuit are typically implemented using a predefined impedance level (e.g. 50 Ohms) with discrete lumped or distributed components which typically forces at least some of the signal handling to be performed in the voltage domain. For example, a radio receiver may be exposed to signals with varying power levels that depend on different parameters, such as the power levels of the transmitters and the distances between the transmitters and the receiver.

Thus, implementing a receiver using CMOS technology with a breakdown voltage below anticipated maximum signal levels may result in severe robustness problems. Since the level of the experienced received signal power and its duration will typically be very different for different receivers, it may be hard to specify an expected lifetime and a many receivers may experience performance degradation or even complete break down before their specified lifetime.

Therefore, there is a need for methods and arrangements for control of excess signal (e.g. voltage) levels.

### Summary

It should be emphasized that the term "comprises/comprising" when used in this specification is taken to specify the presence of stated features, integers, steps, or components, but does not preclude the presence or addition of one or more other features, integers, steps, components, or groups thereof.

It should also be noted that "excess signal level" and similar notations may include one or more of the examples excess voltage level and excess current level as applicable. Correspondingly, when the term "excess voltage level" or the term "excess current level" or any other similar term is used as an example, it should be understood that - more generally - excess signal level may be equally applicable.

It is an object of the present invention to provide an attenuator control for a signal processing chain as set out in the independent claims. It is an object of some embodiments to obviate at least some of the above disadvantages and to provide for improved attenuator control.

According to a first aspect, this is achieved by an attenuator control method of a signal processing chain comprising two or more signal processing units, wherein one of the two or more signal processing units is a signal attenuator adapted to apply adaptive signal attenuation of an attenuator input signal based on one or more attenuation parameters to provide an attenuator output signal.

At least one of the two or more signal processing units has an associated wearout process and a corresponding wearout budget, wherein a wearout event of the wearout process occurs when a level of a wearout indication signal of the signal processing chain is in a wearout region, and wherein the wearout process is modeled by a wearout event cost associated with a corresponding wearout event.

The method comprises obtaining an indication of whether a wearout event of the wearout process has occurred. The method further comprises (if the obtained indication shows that a wearout event of the wearout process has occurred) updating a wearout accumulation metric of the wearout process by the associated wearout event cost, comparing the wearout accumulation metric of the wearout process with one or more wearout thresholds of the wearout process, and adapting the attenuation parameters of the signal attenuator based on the comparison. The method also comprises controlling the signal attenuator based on the attenuation parameters.

In some embodiments, the two or more signal processing units may further comprise an amplifier, e.g. a low noise amplifier (LNA), adapted to receive the attenuator output signal as an amplifier input signal. In those embodiments, the at least one of the two or more signal processing units may comprise one or more of the signal attenuator and the amplifier.

According to some embodiments, the signal attenuator may be controlled by an attenuator controller comprising an automatic gain control (AGC) function and the attenuation parameters may comprise AGC parameters.

The method may be performed repeatedly according to various embodiments. For example, the method may be repeated at regular time intervals.

The one or more wearout thresholds may define at least a budget over-consumption domain according to some embodiments. Adapting the attenuation parameters of the signal attenuator based on the comparison may then comprise adapting the attenuation parameters of the signal attenuator to decrease a wearout event occurrence probability if the wearout accumulation metric falls in the budget over-consumption domain.

Alternatively or additionally, the one or more wearout thresholds may define a budget under-consumption domain according to some embodiments. Adapting the attenuation parameters of the signal attenuator based on the comparison may then comprise adapting the attenuation parameters of the signal attenuator to increase a wearout event occurrence probability if the wearout accumulation metric falls in the budget under-consumption domain.

Yet alternatively or additionally, the one or more wearout thresholds may define an acceptable budget consumption domain according to some embodiments. If the wearout accumulation metric falls in the acceptable budget consumption domain, the method may comprise keeping the attenuation parameters (i.e. their current values) of the signal attenuator.

In some embodiments, a plurality of the two or more signal processing units may have a respective associated wearout process. Alternatively or additionally, at least one of the two or more signal processing units may have a plurality of respective associated wearout processes. In any of these embodiments, the one or more wearout thresholds may define at least a budget over-consumption domain of the respective wearout process and obtaining the indication, updating the wearout accumulation metric and comparing it with one or more wearout thresholds may be performed for each of the respective wearout processes.

In embodiments where there are a plurality of wearout processes, adapting the attenuation parameters of the signal attenuator based on the comparison may, for example, comprise adapting the attenuation parameters of the signal attenuator to decrease a wearout event occurrence probability if the wearout accumulation metric of at least one of the respective wearout processes falls in the respective budget over-consumption domain. Furthermore, the one or more wearout thresholds may define at least a budget under-consumption domain of the respective wearout process, and adapting the attenuation parameters of the signal attenuator based on the comparison may comprise adapting the attenuation parameters of the signal attenuator to increase the wearout event occurrence probability if the wearout accumulation metric of all of the wearout processes falls in the respective budget under-consumption domain. Otherwise, the attenuation parameters of the signal attenuator may be kept unchanged according to some embodiments.

Alternatively, in embodiments where there are a plurality of wearout processes, adapting the attenuation parameters of the signal attenuator based on the comparison may comprise, for each of the respective wearout processes, determining intermediate attenuation parameters defining a decreased wearout event occurrence probability if the wearout accumulation metric of the wearout process falls in the budget over-consumption domain (and/or defining an increased wearout event occurrence probability if the wearout accumulation metric of the wearout process falls in the budget under-consumption domain), and adapting the attenuation parameters based on a weighted sum, over the wearout processes, of the intermediate attenuation parameters.

Adaptation of the attenuation parameters may, for example, comprise varying the time characteristics (e.g. waiting times, step sizes or change rates, etc.) of the attenuator control and/or varying the minimum and/or maximum allowed attenuation. In some embodiments, the attenuation parameters of the signal attenuator may comprise one or more of a maximum allowed attenuation, a minimum allowed attenuation, an attenuation increase step size, an attenuation decrease step size, an attenuation increase time hysteresis, an attenuation decrease time hysteresis, a maximum allowed attenuation increase rate, a maximum allowed attenuation decrease rate, an attenuation increase threshold bias to the damage budget average consumption function for providing one of the damage budget thresholds, an attenuation decrease threshold bias of the damage budget average consumption function for providing one of the damage budget thresholds, and one or more attenuation parameter weights.

According to some embodiments, each of the one or more wearout thresholds may be a function of a current age of the signal processing chain, the function being based on the wearout budget and a target wearout time of the wearout process.

If there are two or more thresholds, they may, for example, be defined by a single function plus and minus (respectively) a hysteresis value. If the wearout accumulation metric is initiated to zero and the wearout event costs increment the wearout accumulation metric, the function may typically be related to an increasing function from <time,function> = <0,0> to <time,function> = <target_wearout_time,wearout_budget>. If the wearout accumulation metric is initiated to the wearout budget and the wearout event costs decrement the wearout accumulation metric, the function may typically be related to a decreasing function from <time,function> = <0,wearout_budget> to <time,function> = <target_wearout_time,0>. In some embodiments, the functions are linear functions.

The wearout processes may be statistical processes and may be determined by measurements on an ensemble of signal processing chains comprising the one or more signal processing units. Alternatively or additionally, the statistical processes may be determined from measurements on ensembles of individual devices from which the signal processing units are built. The statistical process may define the wearout event cost, which may be a fix value or a variable that depends on e.g. the level of the wearout indication signal and/or on the duration of the level of the wearout indication signal being in the wearout region. The wearout event cost may also vary over time (e.g. the cost being higher the more wearout events having been previously experienced).

The wearout budget may, for example, be used to initiate the wearout accumulation metric and/or for defining the one or more wearout thresholds. The one or more wearout thresholds may, for example, comprise one threshold distinguishing the budget over-consumption domain from the budget under-consumption domain, or two thresholds together defining the budget over-consumption domain, the budget under-consumption domain and a domain with acceptable budget consumption (lying between the two thresholds). However, more thresholds may be applied according to some embodiments. For example, the budget over-consumption domain may be divided into two or more sub-domains where different adaptation of the attenuation parameters is applied, and similarly for the budget under-consumption domain.

A second aspect is a computer program product comprising a computer readable medium having thereon a computer program comprising program instructions, the computer program being loadable into a data-processing unit and adapted to cause execution of the method according to the first aspect when the computer program is run by the data-processing unit.

According to a third aspect, an attenuator control arrangement of a signal processing chain comprising two or more signal processing units is provided. One of the two or more signal processing units is a signal attenuator. At least one of the two or more signal processing units has an associated wearout process and a corresponding wearout budget, wherein a wearout event of the wearout process occurs when a level of a wearout indication signal of the signal processing chain is in a wearout region, and wherein the wearout process is modeled by a wearout event cost associated with a corresponding wearout event.

The arrangement comprises the signal attenuator and an attenuation controller. The signal attenuator is adapted to apply adaptive signal attenuation of an attenuator input signal based on one or more attenuation parameters to provide an attenuator output signal.

The attenuation controller is adapted to control the signal attenuator based on the attenuation parameters. It is further adapted to obtain an indication of whether a wearout event of the wearout process has occurred, and (in response to the obtained indication showing that a wearout event of the wearout process has occurred) update a wearout accumulation metric of the wearout process by the associated wearout event cost, compare the wearout accumulation metric of the wearout process with one or more wearout thresholds of the wearout process, and adapt the attenuation parameters of the signal attenuator based on the comparison.

The attenuation controller may, according to some embodiments, comprise an automatic gain controller and a wearout process administrator. The automatic gain controller may be adapted to control the signal attenuator based on the attenuation parameters, obtain the indication of whether a wearout event of the wearout process has occurred, and provide the indication of whether a wearout event of the wearout process has occurred to the wearout process controller. The wearout process administrator may be adapted to (in response to the obtained indication showing that a wearout event of the wearout process has occurred) update the wearout accumulation metric of the wearout process by the associated wearout event cost, compare the wearout accumulation metric of the wearout process with the one or more wearout thresholds of the wearout process, adapt the attenuation parameters of the signal attenuator based on the comparison, and provide the adapted attenuation parameters to the automatic gain controller.

A fourth aspect is an electronic apparatus comprising the arrangement according to the third aspect. The electronic device may be a wireless communication device, a wireless communication modem or a wireless communication receiver.

In some embodiments, the third and fourth aspects may additionally have features identical with or corresponding to any of the various features as explained above for the first aspect.

An advantage of some embodiments is that the probability of breakdown of each component (and consequently of the entire signal processing chain) may be controlled. Thus, the probability may be decreased or minimized. There is also a possibility to trade-off the probability against attenuation aggressiveness. For example, the probability of breakdown before the target lifetime of the product comprising the signal processing chain may be kept below a certain value, while the probability of breakdown after the target lifetime may be allowed to be high. In such a scenario, the attenuation parameters may be chosen just cautiously enough to fulfill the first requirement.

Another advantage of some embodiments is that the probability of the signal processing chain (and thus the product comprising it) being specification compliant during its target lifetime may be increased.

### Brief Description of the Drawings

Further objects, features and advantages will appear from the following detailed description of embodiments, with reference being made to the accompanying drawings, in which:
Figs. 1A and 1B are flowcharts illustrating example method steps according to some embodiments;
Fig. 2 is a block diagram illustrating an example arrangement according to some embodiments; and
Fig. 3 is a schematic drawing illustrating a computer readable medium according to some embodiments.

### Detailed Description

As mentioned above, the typical radio receiver may comprise an automatic gain control (AGC) function that controls at least the attenuator to regulate the overall gain of the receiver. As is also mentioned above, the receiver may be subject to long durations of high excess signal (e.g. voltage) levels, which - if not counteracted - result in performance degradation and in the worst case component break down of at least one component of the receiver chain (typically the LNA and/or the attenuator). This will typically severally reduce the lifetime of the product comprising the receiver chain. The product lifetime may depend on the actual breakdown of a component, but may also depend on the time it takes until a component is pushed outside its specified performance limit due to parameter drift.

In the following, embodiments will be described where an attenuation control method implements protection against excess signal levels (e.g. saturations and other high magnitude signal levels). The excess signal levels may, for example be in the form of excess voltage levels and/or excess current levels.

The attenuation control method may, for example, be associated with an automatic gain control (AGC) function adapted to minimize the exposure of the LNA and/or other relevant receiver block to excess signal levels. The operation of the AGC function may typically be based on an estimate of the total signal power (or the equivalent signal voltage and/or current) as seen, for example, at the input (and/or other node) of the attenuator, at the input (and/or other node) of the LNA, and/or at the input (and/or other node) of another relevant receiver block. The estimate of the signal level for a particular victim block (the block that suffers performance degradation at an excess signal level) may be obtained from direct measurements on the victim block or indirectly by calculations (e.g. based on measurements performed later in the receiver chain, for example in the digital domain).

Through the control of the AGC function, the attenuator typically applies a higher attenuation when the total input signal power is high than when the total input signal power is low, to protect the components of the receiver chain against excess signal levels. Even if the AGC function is adapted to provide counteraction of excess signal levels, there is typically still a period of time between the signal increase and the corresponding change in attenuation, during which the signal increase is not properly counteracted. This time period latency is partly due to the time that passes between a signal entering the attenuator and the corresponding signal being measurable (for AGC purposes) later in the receiver chain. Furthermore, the measuring operation itself may take some time as well as the reconfiguration of the attenuator (e.g. internal AGC operations and changing the attenuation parameters). Thus, the components of the receiver chain will be exposed to excess signal levels during this time period, which may be particularly damaging if, for example, an abrupt signal level increase occurs. Embodiments will also be described where the attenuation control is dynamically adapted to control the time period of exposure to excess signal levels.

According to a typical embodiment, an AGC function is augmented such that it monitors (for one or more signal processing units) the accumulated damage experienced by the unit due to excess signal levels, and controls the attenuation to avoid that the unit breaks down before the stipulated lifetime of the product. For example, an average accumulated damage per time unit may be kept below a certain value that may depend on the lifetime.

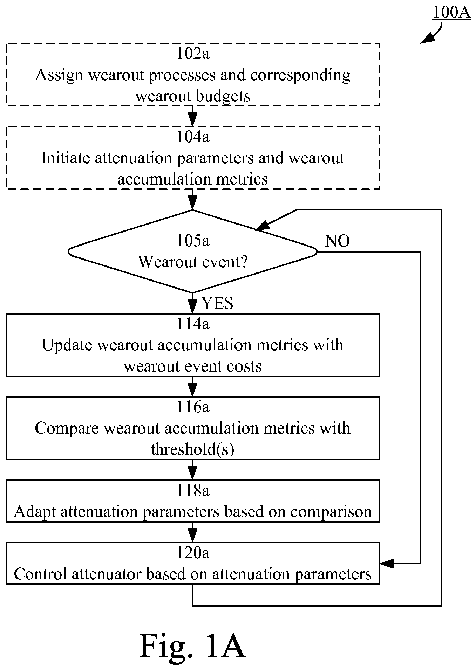

Figure 1A illustrates an example method 100A for attenuator control according to some embodiments. The method 100A may be applied to a signal processing chain comprising one or more signal processing units (e.g. an attenuator, an LNA, etc.) wherein one or more of the signal processing units are damaged if a signal level (e.g. at the input of the signal processing unit under consideration) is above a certain level. The term damage when used herein should be understood to comprise component breakdown, and may also comprise other component injuries such as performance degradation (e.g. due to parameter drift). The collective damages contribute to a wearout of the unit.

In step 102a, one or more wearout processes and corresponding wearout budgets are assigned to one or more signal processing units of the signal processing chain, and in step 104a, a wearout accumulation metric is initiated for each process. Typically, each process has a target wearout time, which is a measure of how long the associated signal processing unit (or the part of the associated signal processing unit related to the particular process) is expected to be functional. Furthermore, there is a product lifetime which is a measure of how long the product comprising the signal processing chain is expected to be functional. In one example, all target wearout times are equal to or larger than the product lifetime since a malfunction of one part typically causes malfunction of the entire product. In another example, some target wearout times may be smaller than the product lifetime (e.g. if there are redundant components in the implementation).

Initial attenuation parameter values are also set in step 104a. Steps 102a and 104a, which are typically performed only once for each device - in connection with the design, construction or production of the device, may or may not be seen as part of the method.

A typical example attenuator may provide M attenuation levels L₁,..,L_{M}, where L₁ is the lowest attenuation and L_{M} the highest attenuation. Also typically, higher attenuation generally leads to lower stress both for the LNA and the attenuator itself. A minimum attenuation L_{MIN} may be defined which specifies the minimum attenuation currently allowed.

Generally, the attenuation parameters may comprise any suitable known or future attenuation parameters, e.g. AGC parameters, and the initial attenuation parameters may be set according to any suitable known or future method. Some examples of suitable attenuation parameters include a maximum allowed attenuation, a minimum allowed attenuation, an attenuation increase step size, an attenuation decrease step size, an attenuation increase time hysteresis, an attenuation decrease time hysteresis, a maximum allowed attenuation increase rate, a maximum allowed attenuation decrease rate, an attenuation increase threshold bias to the damage budget average consumption function for providing one of the damage budget thresholds, an attenuation decrease threshold bias of the damage budget average consumption function for providing one of the damage budget thresholds, and one or more attenuation parameter weights.

The wearout accumulation metric may, for example, be initiated to zero or to the wearout budget of the corresponding process. The wearout budget is a measure of the collective damage a unit may be exposed to (e.g. before its performance is degraded or it is broken).

It is determined in step 105a whether or not a wearout event has occurred. This determination may be based on obtaining a suitable indication (e.g. in the form of AGC metrics). Various metrics may be used to obtain the indication, e.g. a received signal strength indicator (RSSI), momentary and/or average power levels at different nodes of the signal processing chain (in analog or/and digital domain), and/or estimated signal-to-noise ratio (SNR). In a typical example, measurements of one or more signals along the signal processing chain are performed and the determination is based thereon. For example, a signal level at an output of the attenuator falling above an attenuator output threshold may indicate a wearout event. One or more measured analog or digital signals from various parts of the signal processing chain may be used alone or in combination to make the determination. Different indications and/or different thresholds may be applied for different processes.

If a wearout event has not occurred (NO-path out from step 105a) the method proceeds to step 120a, where the attenuator is controlled based on current (i.e. the previously set) attenuation parameters.

If a wearout event has occurred (YES-path out from step 105a) the wearout accumulation metrics of the relevant processes are updated with corresponding wearout event costs in step 114a. Depending on the implementation, the updating may comprise incrementing or decrementing the wearout accumulation metrics by the corresponding wearout event cost. The wearout event costs may depend on the signal level and its duration (e.g. the amount of time the signal level is above a certain value). The costs may vary over time, may be the same or different for different wearout processes, and may be pre-calculated or calculating during operation. Typically, a higher stress (e.g. higher signal level, longer duration, etc.) experienced by the signal processing unit under consideration should be associated with a higher cost.

There may be several wearout event types (each having a corresponding cost) associated with each wearout process. Alternatively, an implementation may comprise assigning a separate wearout process for each type of wearout event.

The wearout accumulation metric is compared with one or more thresholds in step 116a and the attenuation parameters are adapted based on the comparison in step 118a. The one or more thresholds may be associated with respective functions over time (e.g. functions of a current age of the signal processing chain). The functions are typically based on the wearout budget and a target wearout time of the wearout process. The adaptation of the attenuation parameters may be performed by requesting a change to specified absolute parameter values or by requesting a relative increment or decrement of the parameter values.

In an example with two thresholds, they are defined by a single function plus/minus a hysteresis value. In an example with one threshold, it is defined by the single function directly. If the wearout accumulation metric is initiated to zero, the wearout event costs typically increment the wearout accumulation metric and the single function is typically an increasing function from <0,0> to <target_wearout_time,wearout_budget>. If the wearout accumulation metric is initiated to the wearout budget, the wearout event costs typically decrement the wearout accumulation metric and the function is typically a decreasing function from <0,wearout_budget> to <target_wearout_time,0>.

After adaptation of the attenuation parameters, the method proceeds to step 120a where the attenuator is controlled based on current (i.e. adapted) attenuation parameters.

Method steps 105a, 114a, 116a, 118a and 120a may be performed repeatedly (e.g. at regular time intervals) throughout the lifetime of the product it is applied to.

The adaptation of the attenuation parameters in step 118a aims to regulate the wearout events such that the time it takes to consume the wearout budget is equal or close to the target wearout time of the corresponding process.

For example, if the comparison shows that the unit has suffered too much damage to last as long as it should, a more cautious attenuation may be applied. Similarly, if the comparison shows that the unit has suffered very little damage, a less cautious attenuation may be applied. A cautious attenuation may, for example, be characterized by one or more of long waiting times until reacting on a signal decrease, short waiting times until reacting on a signal increase, a high minimum attenuation, a high maximum attenuation, a rapid attenuation increase rate, a slow attenuation decrease rate, a large attenuation increase step size, and a small attenuation decrease step size.

In a typical implementation, the one or more thresholds of step 116a may define a budget over-consumption domain and a budget under-consumption domain. If the wearout accumulation metric falls in the budget over-consumption domain (i.e. too much damage) the adaptation of step 118a decreases the probability of future wearout events, and if the wearout accumulation metric falls in the budget under-consumption domain (i.e. very little damage) the adaptation of step 118a increases the probability of future wearout events. When there are two thresholds in step 116a, a domain with acceptable budget consumption (where no adaptation is needed in step 118a) may be defined between the thresholds.

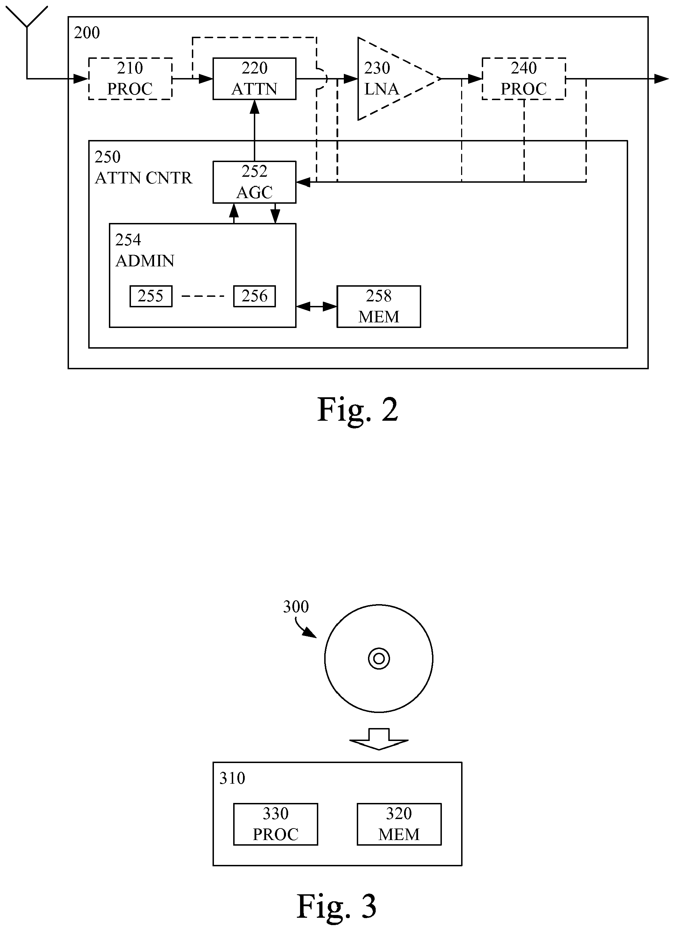

In an example embodiment, each wearout process pᵢ (which may in turn comprise a group of wearout processes combined together) is modeled in relation to a victim device or group of victim devices (e.g. a signal processing unit), and the wearout process modeling may be administered within the device itself or within a separate wearout process administrator (as will be exemplified later, in Figure 2).

Each wearout process of the example embodiment has an associated damage budget (i.e. wearout budget) defined by an assigned number of tokens N_{T0}. The wearout accumulation metric may be initiated to N_{T0} according to this example embodiment. A target lifetime (i.e. target wearout time) T_{L} is specified for each wearout process, wherein the target lifetime of a wearout process is typically larger than the lifetime of the entire product (e.g. a radio receiver).

In the example embodiment, each event of excess signal level (i.e. wearout event) generates a token toll (i.e. wearout event cost) for each respective wearout process. Thus, according to this example embodiment, a number of tokens are consumed each time a wearout event (i.e. something that is known to possibly damage the unit associated with the wearout event) occurs. This may be viewed as the wearout accumulation metric being decreased by the number of tokens (i.e. the wearout event cost).

The cost of a specific event may be a function (possibly, but typically not, linear) of the excess signal level and its duration. To establish an accurate representation of the relationship between an event and its cost may be a part of the modeling process. One simple form of cost function may be a binary function, i.e. a fixed amount of tokens is consumed every time a signal level is above a certain (predefined) level.

One purpose of the attenuation control according to this example embodiment is to ensure that, for each wearout process, the number of tokens N_{T0} initially assigned will not be consumed before the specified target lifetime T_{L} for the wearout process has elapsed. This can be achieved, for example, by ensuring that the token consumption rate (average number of tokens consumed per time unit) is equal to or less than N_{T0}/T_{L}. The token consumption rate at an age T_{A} of the device may, for example, be calculated as (N_{T0}-N_{T})/T_{A}, where N_{T} is the value of the wearout accumulation metric, i.e. the number of tokens remaining at T_{A}. Thus, it should be determined whether or not (N_{T0}-N_{T})/T_{A} > N_{T0}/T_{L}. If so, the consumption rate is too high and the attenuation parameters should be adapted to lower the consumption rate. In the language of Figure 1A, step 116a, the determination of whether or not (N_{T0}-N_{T})/T_{A} > N_{T0}/T_{L} corresponds to comparing N_{T} with a threshold N_{T0}(1-T_{A}/T_{L}). More generally, it could be determined at an age T_{A} whether or not each wearout process pᵢ has a specified minimum number of tokens fᵢ(T_{A}) left, i.e. whether or not N_{T} > fᵢ(T_{A}), where fᵢ(T_{A}) is typically a decreasing function from <0, N_{T0}> to < T_{L},0> (or < T_{L}+x,0>, where x>0). For example, fᵢ(T_{A}) may be shaped to allow a higher than average token consumption rate when the device is new, which may be at the potential expense of decreased (protective) performance at higher age, or vice versa.

It should be noted that the token consumption does not necessarily reflect the exact actual wearout status of a device, but is rather a statistical model of typical wearout in an ensemble of devices. Correspondingly, that all of the tokens have been consumed does not necessarily mean that the device is actually broken or out of specification, but rather that there is a certain probability that the device is broken or out of specification. Such a probability may be determined for different ages of a device from statistical measurements on an ensemble of devices and may be used as an input for designing the statistical model that the corresponding wearout process is based on.

Adapting attenuation parameters (to increase or decrease the token consumption rate) may, in this example embodiment, comprise an AGC controlling one or more of the following parameters:
- A minimum and/or maximum allowed attenuation (Lₘᵢₙ, Lₘₐₓ e.g. in dB). For example, a higher minimum and/or maximum attenuation may decrease the token consumption rate.
- An attenuation step size for attenuation increase and/or decrease (ΔL⁺, ΔL⁻ e.g. in dB). For example, a smaller attenuation decrease step size and/or a larger attenuation increase step size may decrease the token consumption rate.
- A time to wait before the attenuation is increased or decreased (T⁺, T⁻ in time units). For example, a longer time to wait before attenuation decrease and/or a shorter time to wait before attenuation increase may decrease the token consumption rate.
- A maximum change rate for attenuation increase and/or decrease (R⁺, R⁻ e.g. in dB per time unit). For example, a higher maximum change rate for attenuation increase and/or a lower maximum change rate for attenuation decrease may decrease the token consumption rate. Regulating the change rate may be seen as a combination of regulating the step size and the time to wait.

- Weighting factors for combining values for several wearout processes of any of the above parameters.
- Weighting factors for combining measurement data collected at different locations in the signal processing chain to obtain a wearout event indication.
- Threshold levels (TH⁺, TH⁻) defining a hysteresis range around fᵢ(T_{A}). For example, a larger hysteresis value TH⁺ and/or a smaller hysteresis value TH⁻ may decrease the token consumption rate.

The hysteresis defines a (possibly variable) region where, if the number of remaining tokens is in this region, no attenuation parameter adaptation is made. If N_{T,i} < fᵢ(T_{A}) - TH⁻, a more proactive token consumption control may be requested to decrease the token consumption rate, if N_{T,i} > fᵢ(T_{A}) + TH⁺, a less proactive token consumption control may be requested to increase the token consumption rate, and if fᵢ(T_{A}) - TH⁻ < N_{T,i} < fᵢ(T_{A}) + TH⁺ no change is made.

Hence, the above examples may be seen as token consumption control parameters, and they may be adjusted to be more or less protective, i.e. adjusted to decrease or increase the probability of excess signal levels (and, thus, the token consumption rate). Furthermore, any of the above example parameters may also be applicable to various other embodiments.

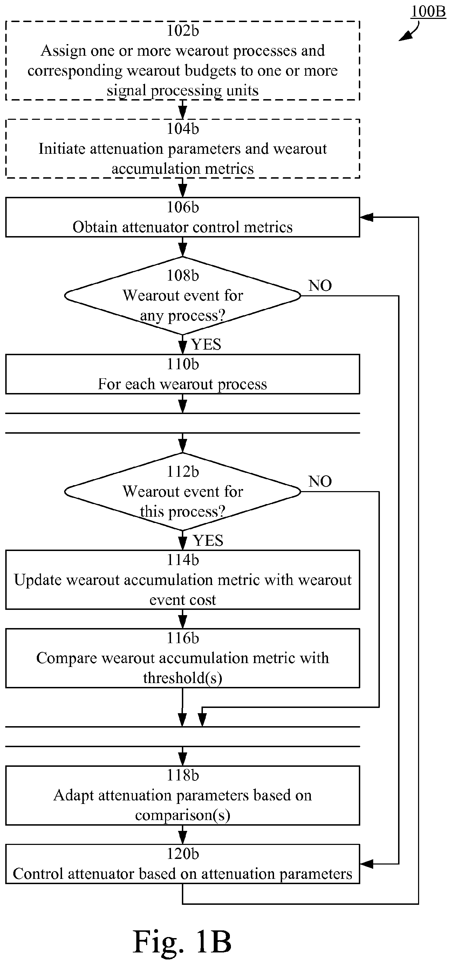

Figure 1B illustrates an example method 100B for attenuator control according to some embodiments. The method 100B is quite similar to method 100A of Figure 1A. Thus, similar steps have been denoted using similar reference numbers and some of those similar steps will not be described in detail. It is understood that details explained in connection to Figure 1A may be applied to Figure 1B as applicable and vice versa.

In step 102b, one or more wearout processes and corresponding wearout budgets are assigned to one or more signal processing units of the signal processing chain, and in step 104b, a wearout accumulation metric is initiated for each process. Initial attenuation parameter values are also set in step 104b.

In step 106b, attenuator control metrics is obtained. The attenuator control metrics may, for example, comprise or be based on one or more measured analog or digital signals from various parts of the signal processing chain as explained in connection to step 105a of Figure 1A. It is determined in step 108b whether a wearout event has occurred for any of the wearout processes.

If no wearout event has occurred (NO-path out from step 108b) the method proceeds to step 120b, where the attenuator is controlled based on current (i.e. the previously set) attenuation parameters.

If at least one wearout event has occurred (YES-path out from step 108b) steps 112b, 114b and 116b are performed for each of the wearout processes as indicated by step 110b.

If no wearout event occurred for the process under consideration (NO-path out from step 112b), steps 114b and 116b are not performed for that process.

If a wearout event occurred for the process under consideration (YES-path out from step 112b), the wearout accumulation metric of that process is updated with the corresponding wearout event cost in step 114b and the wearout accumulation metric is compared with one or more thresholds in step 116b.

In step 118b, the attenuation parameters are adapted based on the comparisons in step 116b, and after adaptation of the attenuation parameters the method proceeds to step 120b where the attenuator is controlled based on current (i.e. adapted) attenuation parameters.

It is to be noted that the decisions of steps 108b and 112b may be combined in some implementations. In such an implementation a step determining if a wearout event has occurred is performed for each process after step 106b, and if a wearout event occurred for the process under consideration steps similar to steps 114b and 116b are performed for that process. This is followed by steps similar to steps 118b and 120b if at least one process experienced a wearout event and by a step similar to step 120b if no process experienced a wearout event.

The adaptation of the attenuation parameters of 118a and 118b may be based on various approaches when there are more than one wearout processes. For example, the adaptation may decrease the probability of future wearout events if the wearout accumulation metric of at least one of the wearout processes falls in the respective budget over-consumption domain, and increase the probability of future wearout events only if the wearout accumulation metric of all of the wearout processes falls in the respective budget under-consumption domain. In another example, intermediate attenuation parameters are determined for each wearout process (as if it was the only wearout process) and the adaptation is then based on a weighted sum (e.g. an average) of the intermediate attenuation parameters. The weighted sum may, for example, be over all wearout process or over only the wearout processes that experiences a wearout event. Combinations of the above and other solutions are also possible.

Figure 2 illustrate an example attenuator control arrangement 200 according to some embodiments. The arrangement 200 may, for example, be adapted to perform any of the methods 100A or 100B as described in connection to Figures 1A and 1B respectively.

The arrangement 200 comprises an attenuator (ATTN) 220 and an attenuation controller (ATTN CNTR) 250. The attenuator 220 is arranged in a signal processing chain comprising the attenuator 220 and one or more other signal processing units 210, 230, 240. Typically, the attenuator 220 is operatively connected to a signal receiving and/or transmitting device (e.g. an antenna) via one or more processing units (PROC) 210. The processing unit(s) 210 may be according to any known or future suitable implementation, and may e.g. comprise filters, duplexers, amplifiers, and the like. In a typical receiver structure, the attenuator 220 is followed by an amplifier, e.g. a low noise amplifier (LNA) 230 and other signal processing units (PROC) 240. The processing unit(s) 240 may be according to any known or future suitable implementation, and may e.g. comprise down-conversion mixers, filters, analog-to-digital converters, digital domain signal processing, and the like.

In the example arrangement 200, the attenuation controller 250 comprises an automatic gain controller (AGC) 252, a wearout process administrator (ADMIN) 254 and a memory (MEM) 258. Other structures of the attenuation controller 250 may be applicable in other implementations.

The attenuator 220 is adapted to apply adaptive signal attenuation based on one or more attenuation parameters, and the automatic gain controller is adapted to regulate the attenuation parameters based on signal measurements performed at one or more locations in the signal processing chain (illustrated in Figure 2 by dashed connection lines).

At least one of the signal processing units in the signal processing chain (e.g. the attenuator 220, the LNA 230 and/or the other signal processing units 240) has at least one associated wearout process and a corresponding wearout budget as has been described above. The administration of the wearout process (compare with steps 114a, 116a, 114b, 116b of Figures 1A and 1B) may be handled by the wearout process administrator 254, which is illustrated by the modules 255 and 256 in Figure 2. Various parameters, values and metrics (e.g. threshold values and wearout accumulation metrics) of the wearout processes may be stored in a memory 258 associated with or integral to the wearout process administrator 254.

In a typical implementation, the attenuation controller 250 obtains an indication of whether a wearout event of the wearout process has occurred. For example, the automatic gain controller 252 may determine the indication based on signal measurements (e.g. by comparing a signal level to a threshold) and then provide the indication to the wearout process administrator 254 when a wearout event occurs.

Then, the attenuation controller 250 updates the wearout accumulation metrics by the associated wearout event costs, compares the wearout accumulation metrics with respective wearout thresholds, and adapts the attenuation parameters of the signal attenuator based on the comparison in a similar manner as has been described above. In the example of Figure 2, these operations are performed by the wearout process administrator 254 and the adapted attenuation parameters are provided to the automatic gain controller 252.

The attenuation controller 250 (typically the automatic gain controller 252) is adapted to control the signal attenuator based on the attenuation parameters (whether adapted or not).

By application of embodiments, the probability of malfunctioning of a product or product part may be controlled. Furthermore, the status of a product may be indirectly monitored via monitoring the wearout processes of the product. According to some embodiments, one or more wearout process parameters (e.g. wearout accumulation metric, token consumption rate, tokens left, etc.) may be reported to an operations and maintenance (O&M) system for the product. The parameters may be reported per process or combined per product and may be useful to determine e.g. when it is advisable to provide service to a product, replace parts, or replace the entire product. Reporting may be performed by any known or future methods, e.g. by wireless communication between a mobile terminal and a base station in a cellular communication network and/or by wireline/optical communication from a base station to a receiver of the report.

The described embodiments and their equivalents may be realized in software or hardware or a combination thereof. They may be performed by general-purpose circuits associated with or integral to a communication device, such as digital signal processors (DSP), central processing units (CPU), co-processor units, field-programmable gate arrays (FPGA) or other programmable hardware, or by specialized circuits such as for example application-specific integrated circuits (ASIC). All such forms are contemplated to be within the scope of this disclosure.

Embodiments may appear within an electronic apparatus (such as a wireless communication device) comprising circuitry/logic or performing methods according to any of the embodiments. The electronic apparatus may, for example, be a portable or handheld mobile radio communication equipment, a mobile radio terminal, a mobile telephone, a base station, an access point, a communicator, an electronic organizer, a smartphone, a computer, a notebook, or a mobile gaming device.

According to some embodiments, a computer program product comprises a computer readable medium such as, for example, a diskette, a USB-stick, a plug-in card, an embedded drive, or a CD-ROM (as illustrated by 300 in Figure 3). The computer readable medium 300 may have stored thereon a computer program comprising program instructions. The computer program may be loadable into a data-processing unit 330, which may, for example, be comprised in a base station 310. When loaded into the data-processing unit 330, the computer program may be stored in a memory 320 associated with or integral to the data-processing unit 330. According to some embodiments, the computer program may, when loaded into and run by the data-processing unit 330, cause the data-processing unit 330 to execute method steps according to, for example, the methods shown in any of the Figures 1A and1B.

Reference has been made herein to various embodiments. However, a person skilled in the art would recognize numerous variations to the described embodiments that would still fall within the scope of the claims. For example, the method embodiments described herein describes example methods through method steps being performed in a certain order. However, it is recognized that these sequences of events may take place in another order without departing from the scope of the claims. Furthermore, some method steps may be performed in parallel even though they have been described as being performed in sequence.

In the same manner, it should be noted that in the description of embodiments, the partition of functional blocks into particular units is by no means limiting. Contrarily, these partitions are merely examples. Functional blocks described herein as one unit may be split into two or more units. In the same manner, functional blocks that are described herein as being implemented as two or more units may be implemented as a single unit without departing from the scope of the claims.

Hence, it should be understood that the details of the described embodiments are merely for illustrative purpose and by no means limiting. Instead, all variations that fall within the range of the claims are intended to be embraced therein.

## Claims

1. An attenuator control method of a signal processing chain comprising two or more signal processing units, wherein:
one of the two or more signal processing units is a signal attenuator adapted to apply adaptive signal attenuation of an attenuator input signal based on one or more attenuation parameters to provide an attenuator output signal, and
at least one of the two or more signal processing units has an associated wearout process and a corresponding wearout budget, wherein a wearout event of the wearout process occurs when a level of a wearout indication signal of the signal processing chain is in a wearout region, and wherein the wearout process is modeled by a wearout event cost associated with a corresponding wearout event,
the method comprising:
obtaining (105a, 106b, 108b, 112b) an indication of whether a wearout event of the wearout process has occurred;
if the obtained indication shows that a wearout event of the wearout process has occurred:
updating (114a, 114b) a wearout accumulation metric of the wearout process by the associated wearout event cost;
comparing (116a, 116b) the wearout accumulation metric of the wearout process with one or more wearout thresholds of the wearout process;
adapting (118a, 118b) the attenuation parameters of the signal attenuator based on the comparison; and
controlling (120a, 120b) the signal attenuator based on the attenuation parameters.

2. The method of claim 1 wherein the one or more wearout thresholds define at least a budget over-consumption domain, and wherein adapting (118a, 118b) the attenuation parameters of the signal attenuator based on the comparison comprises adapting the attenuation parameters of the signal attenuator to decrease a wearout event occurrence probability if the wearout accumulation metric falls in the budget over-consumption domain.

3. The method of any of claims 1 through 2 wherein the one or more wearout thresholds define a budget under-consumption domain, and wherein adapting (118a, 118b) the attenuation parameters of the signal attenuator based on the comparison comprises adapting the attenuation parameters of the signal attenuator to increase a wearout event occurrence probability if the wearout accumulation metric falls in the budget under-consumption domain.

4. The method of any of claims 1 through 3 wherein the one or more wearout thresholds define an acceptable budget consumption domain, and wherein the method further comprises keeping the attenuation parameters of the signal attenuator if the wearout accumulation metric falls in the acceptable budget consumption domain.

5. The method of any of claims 1 through 4 wherein at least one of the two or more signal processing units having an associated wearout process comprises one or more of:
a plurality of the two or more signal processing units having a respective associated wearout process; and
at least one of the two or more signal processing units having a plurality of respective associated wearout processes,
wherein obtaining (105a, 106b, 108b, 112b) the indication, updating (114a, 114b) the wearout accumulation metric and comparing (116a, 116b) it with one or more wearout thresholds is performed for each of the respective wearout processes,
wherein the one or more wearout thresholds define at least a budget over-consumption domain of the respective wearout process, and
wherein adapting (118a, 118b) the attenuation parameters of the signal attenuator based on the comparison comprises adapting the attenuation parameters of the signal attenuator to decrease a wearout event occurrence probability if the wearout accumulation metric of at least one of the respective wearout processes falls in the respective budget over-consumption domain.

6. The method of claim 5 wherein the one or more wearout thresholds define at least a budget under-consumption domain of the respective wearout process, and
wherein adapting (118a, 118b) the attenuation parameters of the signal attenuator based on the comparison comprises adapting the attenuation parameters of the signal attenuator to increase the wearout event occurrence probability if the wearout accumulation metric of all of the wearout processes falls in the respective budget under-consumption domain.

7. The method of claim 6 further comprising keeping the attenuation parameters of the signal attenuator otherwise.

8. The method of any of claims 1 through 4 wherein at least one of the two or more signal processing units having an associated wearout process comprises one or more of:
a plurality of the two or more signal processing units having a respective associated wearout process; and
at least one of the two or more signal processing units having a plurality of respective associated wearout processes,
wherein obtaining (105a, 106b, 108b, 112b) the indication, updating (114a, 114b) the wearout accumulation metric and comparing (116a, 116b) it with one or more wearout thresholds is performed for each of the respective wearout processes,
wherein the one or more wearout thresholds define at least a budget over-consumption domain of the respective wearout process, and
wherein adapting (118a, 118b) the attenuation parameters of the signal attenuator based on the comparison comprises:
for each of the respective wearout processes, determining intermediate attenuation parameters defining a decreased wearout event occurrence probability if the wearout accumulation metric of the wearout process falls in the budget over-consumption domain; and
adapting the attenuation parameters based on a weighted sum, over the wearout processes, of the intermediate attenuation parameters.

9. The method of any of claims 1 through 8 wherein the attenuation parameters of the signal attenuator comprise one or more of: a maximum allowed attenuation, a minimum allowed attenuation, an attenuation increase step size, an attenuation decrease step size, an attenuation increase time hysteresis, an attenuation decrease time hysteresis, a maximum allowed attenuation increase rate, a maximum allowed attenuation decrease rate, an attenuation increase threshold bias to the damage budget average consumption function for providing one of the damage budget thresholds, an attenuation decrease threshold bias of the damage budget average consumption function for providing one of the damage budget thresholds, and one or more attenuation parameter weights.

10. The method of any of claims 1 through 9, wherein each of the one or more wearout thresholds is a function of a current age of the signal processing chain, the function being based on the wearout budget and a target wearout time of the wearout process.

11. The method of any of claims 1 through 10 further comprising initiating the wearout accumulation metric to the wearout budget, wherein updating the wearout accumulation metric comprises decreasing the wearout accumulation metric by the wearout event cost.

12. A computer program product comprising a computer readable medium (300), having thereon a computer program comprising program instructions, the computer program being loadable into a data-processing unit (330) and adapted to cause execution of the method according to any of claims 1 through 11 when the computer program is run by the data-processing unit.

13. An attenuator control arrangement of a signal processing chain comprising two or more signal processing units (220, 230, 240), one of the two or more signal processing units being a signal attenuator (220), wherein at least one of the two or more signal processing units has an associated wearout process and a corresponding wearout budget, wherein a wearout event of the wearout process occurs when a level of a wearout indication signal of the signal processing chain is in a wearout region, and wherein the wearout process is modeled by a wearout event cost associated with a corresponding wearout event, the arrangement comprising:
the signal attenuator (220) adapted to apply adaptive signal attenuation of an attenuator input signal based on one or more attenuation parameters to provide an attenuator output signal; and
an attenuation controller (250) adapted to:
control the signal attenuator (220) based on the attenuation parameters;
obtain an indication of whether a wearout event of the wearout process has occurred; and
in response to the obtained indication showing that a wearout event of the wearout process has occurred:
- update a wearout accumulation metric of the wearout process by the associated wearout event cost;
- compare the wearout accumulation metric of the wearout process with one or more wearout thresholds of the wearout process; and
- adapt the attenuation parameters of the signal attenuator based on the comparison.

14. The arrangement of claim 13 wherein the attenuation controller (250) comprises an automatic gain controller (252) and a wearout process administrator (254), and wherein:
the automatic gain controller (252) is adapted to:
control the signal attenuator based on the attenuation parameters;
obtain the indication of whether a wearout event of the wearout process has occurred; and
provide the indication of whether a wearout event of the wearout process has occurred to the wearout process controller; and
the wearout process administrator (254) is adapted to, in response to the obtained indication showing that a wearout event of the wearout process has occurred:
update the wearout accumulation metric of the wearout process by the associated wearout event cost;
compare the wearout accumulation metric of the wearout process with the one or more wearout thresholds of the wearout process;
adapt the attenuation parameters of the signal attenuator based on the comparison; and
provide the adapted attenuation parameters to the automatic gain controller (252).

15. The arrangement of any of claims 13 through 14 wherein the two or more signal processing units (220, 230, 240) further comprise an amplifier (230) adapted to receive the attenuator output signal as an amplifier input signal, and wherein the at least one of the two or more signal processing units comprises one or more of the signal attenuator (220) and the amplifier (230).

16. An electronic apparatus comprising the arrangement according to any of claims 13 through 15.

17. The electronic apparatus according to claim 16 wherein the electronic device is a wireless communication device, a wireless communication modem or a wireless communication receiver.

## Patentansprüche

1. Dämpfersteuerungsverfahren einer Signalverarbeitungskette, die zwei oder mehr Signalverarbeitungseinheiten umfasst, wobei:
eine der zwei oder mehr Signalverarbeitungseinheiten ein Signaldämpfer ist, der so ausgelegt ist, dass er adaptive Signaldämpfung eines Dämpfereingangssignals basierend auf einem oder mehreren Dämpfungsparametern anwendet, um ein Dämpferausgangssignal bereitzustellen, und
mindestens eine der zwei oder mehr Signalverarbeitungseinheiten einen assoziierten Abnutzungsprozess und ein entsprechendes Abnutzungsbudget aufweist, wobei ein Abnutzungsereignis des Abnutzungsprozesses eintritt, wenn ein Pegel eines Abnutzungsanzeigesignals der Signalverarbeitungskette in einer Abnutzungsregion ist, und wobei der Abnutzungsprozess durch Abnutzungsereigniskosten modelliert wird, die mit einem entsprechenden Abnutzungsereignis assoziiert sind,
wobei das Verfahren umfasst:
Einholen (105a, 106b, 108b, 112b) einer Anzeige dessen, ob ein Abnutzungsereignis des Abnutzungsprozesses eingetreten ist;
falls die eingeholte Anzeige zeigt, dass ein Abnutzungsereignis des Abnutzungsprozess eingetreten ist:
Aktualisieren (114a, 114b) einer Abnutzungsakkumulationsmetrik des Abnutzungsprozesses durch die assoziierten Abnutzungsereigniskosten;
Vergleichen (116a, 116b) der Abnutzungsakkumulationsmetrik des Abnutzungsprozesses mit einer oder mehreren Abnutzungsschwellen des Abnutzungsprozesses;
Anpassen (118a, 118b) der Dämpfungsparameter des Signaldämpfers basierend auf dem Vergleich; und
Steuern (120a, 120b) des Signaldämpfers basierend auf den Dämpfungsparametern.

2. Verfahren nach Anspruch 1, wobei die eine oder die mehreren Abnutzungsschwellen mindestens einen Budget-Mehrverbrauchsbereich definieren, und wobei das Anpassen (118a, 118b) der Dämpfungsparameter des Signaldämpfers basierend auf dem Vergleich ein Anpassen der Dämpfungsparameter des Signaldämpfers zum Reduzieren einer Abnutzungsereigniseintrittswahrscheinlichkeit umfasst, falls die Abnutzungsakkumulationsmetrik in den Budget-Mehrverbrauchsbereich fällt.

3. Verfahren nach Anspruch 1, wobei die eine oder die mehreren Abnutzungsschwellen mindestens einen Budget-Minderverbrauchsbereich definieren, und wobei das Anpassen (118a, 118b) der Dämpfungsparameter des Signaldämpfers basierend auf dem Vergleich ein Anpassen der Dämpfungsparameter des Signaldämpfers zum Erhöhen einer Abnutzungsereigniseintrittswahrscheinlichkeit umfasst, falls die Abnutzungsakkumulationsmetrik in den Budget-Minderverbrauchsbereich fällt.

4. Verfahren nach einem der Ansprüche 1 bis 3, wobei die eine oder de mehreren Abnutzungsschwellen einen annehmbaren Budgetverbrauchsbereich definieren, und wobei das Verfahren ferner ein Aufrechterhalten der Dämpfungsparameter umfasst, falls die Abnutzungsakkumulationsmetrik in den annehmbaren Budgetverbrauchsbereich fällt.

5. Verfahren nach einem der Ansprüche 1 bis 4, wobei mindestens eine der zwei oder mehr Signalverarbeitungseinheiten mit einem assoziierten Abnutzungsprozess eine oder mehrere umfasst von:
einer Mehrzahl der zwei oder mehr Signalverarbeitungseinheiten mit einem jeweiligen assoziierten Abnutzungsprozess; und
mindestens einer der zwei oder mehr Signalverarbeitungseinheiten mit einer Mehrzahl von jeweiligen assoziierten Abnutzungsprozessen,
wobei das Einholen (105a, 106b, 108b, 112b) der Anzeige, das Aktualisieren (114a, 114b) der Abnutzungsakkumulationsmetrik und das Vergleichen (116a, 116b) derselben mit einer oder mehreren Abnutzungsschwellen für jeden der jeweiligen Abnutzungsprozesse durchgeführt wird,
wobei die eine oder die mehreren Abnutzungsschwellen mindestens einen Budget-Mehrverbrauchsbereich des jeweiligen Abnutzungsprozesses definieren, und
wobei das Anpassen (118a, 118b) der Dämpfungsparameter des Signaldämpfers basierend auf dem Vergleich ein Anpassen der Dämpfungsparameter des Signaldämpfers zum Reduzieren einer Abnutzungsereigniseintrittswahrscheinlichkeit umfasst, falls die Abnutzungsakkumulationsmetrik mindestens eines der jeweiligen Abnutzungsprozesse in den jeweiligen Budget-Mehrverbrauchsbereich fällt.

6. Verfahren nach Anspruch 5, wobei die eine oder die mehreren Abnutzungsschwellen mindestens einen Budget-Minderverbrauchsbereich des jeweiligen Abnutzungsprozesses definieren, und
wobei das Anpassen (118a, 118b) der Dämpfungsparameter des Signaldämpfers basierend auf dem Vergleich ein Anpassen der Dämpfungsparameter des Signaldämpfers zum Erhöhen der Abnutzungsereigniseintrittswahrscheinlichkeit umfasst, falls die Abnutzungsakkumulationsmetrik aller Abnutzungsprozesse in den jeweiligen Budget-Minderverbrauchsbereich fällt.

7. Verfahren nach Anspruch 6, andernfalls ferner umfassend ein Aufrechterhalten der Dämpfungsparameter des Signaldämpfers.

8. Verfahren nach einem der Ansprüche 1 bis 4, wobei mindestens eine der zwei oder mehr Signalverarbeitungseinheiten mit einem assoziierten Abnutzungsprozess eine oder mehrere umfasst von:
einer Mehrzahl der zwei oder mehr Signalverarbeitungseinheiten mit einem jeweiligen assoziierten Abnutzungsprozess; und
mindestens einer der zwei oder mehr Signalverarbeitungseinheiten mit einer Mehrzahl von jeweiligen assoziierten Abnutzungsprozessen,
wobei das Einholen (105a, 106b, 108b, 112b) der Anzeige, das Aktualisieren (114a, 114b) der Abnutzungsakkumulationsmetrik und das Vergleichen (116a, 116b) derselben mit einer oder mehreren Abnutzungsschwellen für jeden der jeweiligen Abnutzungsprozesse durchgeführt werden,
wobei die eine oder die mehreren Abnutzungsschwellen mindestens einen Budget-Mehrverbrauchsbereich des jeweiligen Abnutzungsprozesses definieren, und
wobei das Anpassen (118a, 118b) der Dämpfungsparameter des Signaldämpfers basierend auf dem Vergleich umfasst:
Bestimmen für jeden der jeweiligen Abnutzungsprozesse von Zwischendämpfungsparametern, die eine reduzierte Abnutzungsereigniseintrittswahrscheinlichkeit definieren, falls die Abnutzungsakkumulationsmetrik des Abnutzungsprozesses in den Budget-Mehrverbrauchsbereich fällt; und
Anpassen der Dämpfungsparameter basierend auf einer gewichteten Summe über die Abnutzungsprozesse der Zwischendämpfungsparameter.

9. Verfahren nach einem der Ansprüche 1 bis 8, wobei die Dämpfungsparameter des Signaldämpfer ferner eines oder mehreres umfassen von: einer maximal zulässigen Dämpfung, einer mindestzulässigen Dämpfung, einer Dämpfungssteigerungsstufengröße, einer Dämpfungsherabsetzungsstufengröße, einer Dämpfungssteigerungszeithysterese, Dämpfungsherabsetzungszeithysterese, einer maximal zulässigen Dämpfungssteigerungsrate, einer maximal zulässigen Dämpfungsherabsetzungsrate, einem Dämpfungssteigerungsschwellenbias für die Schadensbudget-Durchschnittsverbrauchsfunktion zum Bereitstellen einer der Schadensbudgetschwellen, einem Dämpfungsherabsetzungsschwellenbias für die Schadensbudget-Durchschnittsverbrauchsfunktion zum Bereitstellen einer der Schadensbudgetschwellen und einem oder mehreren Dämpfungsparametergewichte.

10. Verfahren nach einem der Ansprüche 1 bis 9, wobei jede der einen oder der mehreren Abnutzungsschwellen eine Funktion eines aktuellen Alters der Signalverarbeitungskette ist, wobei die Funktion auf dem Abnutzungsbudget und einer Zielabnutzungszeit des Abnutzungsprozesses basiert.

11. Verfahren nach einem der Ansprüche 1 bis 10, ferner umfassend ein Initiieren der Abnutzungsakkumulationsmetrik für das Abnutzungsbudget, wobei das Aktualisieren der Abnutzungsakkumulationsmetrik ein Herabsetzen der Abnutzungsakkumulationsmetrik um die Abnutzungsereigniskosten umfasst.

12. Computerprogrammprodukt, umfassend ein computerlesbares Medium (300), das ein Computerprogramm darauf aufweist, das Programmanweisungen umfasst, wobei das Computerprogramm in eine Datenverarbeitungseinheit (330) geladen werden kann und so ausgelegt ist, dass es die Ausführung des Verfahrens nach einem der Ansprüche 1 bis 11 bewirkt, wenn das Computerprogramm durch die Datenverarbeitungseinheit ausgeführt wird.

13. Dämpfersteuerungsanordnung einer Signalverarbeitungskette, die zwei oder mehr Signalverarbeitungseinheiten (220, 230, 240) umfasst, wobei eine der zwei oder mehr Signalverarbeitungseinheiten ein Signaldämpfer (220) ist, wobei mindestens eine der zwei oder mehr Signalverarbeitungseinheiten einen assoziierten Abnutzungsprozess und ein entsprechendes Abnutzungsbudget aufweist, wobei ein Abnutzungsereignis des Abnutzungsprozesses eintritt, wenn ein Pegel eines Abnutzungsanzeigesignals der Signalverarbeitungskette in einer Abnutzungsregion ist, und wobei der Abnutzungsprozess durch Abnutzungsereigniskosten modelliert wird, die mit einem entsprechenden Abnutzungsereignis assoziiert sind, wobei die Anordnung umfasst:
den Signaldämpfer (220), der so ausgelegt ist, dass er adaptive Signaldämpfung eines Dämpfereingangssignals basierend auf einem oder mehreren Dämpfungsparametern anwendet, um ein Dämpferausgangssignal bereitzustellen; und
eine Dämpfungssteuerung (250), die ausgelegt ist zum:
Steuern des Signaldämpfers (220) basierend auf den Dämpfungsparametern;
Einholen einer Anzeige dessen, ob ein Abnutzungsereignis des Abnutzungsprozesses eingetreten ist; und
in Reaktion darauf, dass die eingeholte Anzeige zeigt, dass ein Abnutzungsereignis des Abnutzungsprozess eingetreten ist:
- Aktualisieren einer Abnutzungsakkumulationsmetrik des Abnutzungsprozesses durch die assoziierten Abnutzungsereigniskosten;
- Vergleichen der Abnutzungsakkumulationsmetrik des Abnutzungsprozesses mit einer oder mehreren Abnutzungsschwellen des Abnutzungsprozesses; und
- Anpassen der Dämpfungsparameter des Signaldämpfers basierend auf dem Vergleich.

14. Anordnung nach Anspruch 13, wobei die Dämpfungssteuerung (240) eine automatische Verstärkungssteuerung (252) und einen Abnutzungsprozessverwalter (254) umfasst, und wobei:
die automatische Verstärkungssteuerung (252) ausgelegt ist zum:
Steuern des Signaldämpfers basierend auf den Dämpfungsparametern;
Einholen der Anzeige dessen, ob ein Abnutzungsereignis des Abnutzungsprozesses eingetreten ist; und
Bereitstellen der Anzeige dessen, ob ein Abnutzungsereignis des Abnutzungsprozesses eingetreten ist, für die Abnutzungsprozesssteuerung; und
der Abnutzungsprozessverwalter (254) so ausgelegt ist, dass er in Reaktion darauf, dass die eingeholte Anzeige zeigt, dass ein Abnutzungsereignis des Abnutzungsprozess eingetreten ist:
eine Abnutzungsakkumulationsmetrik des Abnutzungsprozesses durch die assoziierten Abnutzungsereigniskosten aktualisiert;
die Abnutzungsakkumulationsmetrik des Abnutzungsprozesses mit einer oder mehreren Abnutzungsschwellen des Abnutzungsprozesses vergleicht;
die Dämpfungsparameter des Signaldämpfers basierend auf dem Vergleich anpasst; und
die angepassten Dämpfungsparameter für die automatische Verstärkungssteuerung (252) bereitstellt.

15. Anordnung nach einem der Ansprüche 13 bis 14, wobei die zwei oder mehr Signalverarbeitungseinheiten (220, 230, 240) ferner einen Verstärker (230) umfassen, der so ausgelegt ist, dass er das Dämpferausgangssignal als ein Verstärkereingangssignal empfängt, und wobei die mindestens eine der einen oder mehr Signalverarbeitungseinheiten einen oder mehrere des Signaldämpfers (220) und des Verstärkers (230) umfasst.

16. Elektronische Vorrichtung, umfassend die Anordnung nach einem der Ansprüche 13 bis 15.

17. Elektronische Vorrichtung nach Anspruch 16, wobei die elektronische Vorrichtung eine drahtlose Kommunikationsvorrichtung, ein drahtloses Kommunikationsmodem oder ein drahtloser Kommunikationsempfänger ist.

## Revendications

1. Procédé de commande d'atténuateur d'une chaîne de traitement de signal comprenant deux unités de traitement de signal ou plus, dans lequel :
l'une des deux unités de traitement de signal ou plus est un atténuateur de signal apte à appliquer une atténuation de signal adaptative d'un signal d'entrée d'atténuateur sur la base d'un ou plusieurs paramètres d'atténuation pour fournir un signal de sortie d'atténuateur, et
au moins l'une des deux unités de traitement de signal ou plus comporte un processus d'usure associé et un budget d'usure correspondant, dans lequel un événement d'usure du processus d'usure survient lorsqu'un niveau d'un signal d'indication d'usure de la chaîne de traitement de signal se trouve dans une région d'usure, et dans lequel le processus d'usure est modélisé par un coût d'événement d'usure associé à un événement d'usure correspondant,
le procédé comprenant :
l'obtention (105a, 106b, 108b, 112b) d'une indication de survenance d'un événement d'usure du processus d'usure ;
si l'indication obtenue indique qu'un événement d'usure du processus d'usure est survenu :
la mise à jour (114a, 114b) d'une métrique d'accumulation d'usure du processus d'usure par le coût d'événement d'usure associé ;
la comparaison (116a, 116b) de la métrique d'accumulation d'usure du processus d'usure à un ou plusieurs seuils d'usure du processus d'usure ;
l'adaptation (118a, 118b) des paramètres d'atténuation de l'atténuateur de signal sur la base de la comparaison ; et
la commande (120a, 120b) de l'atténuateur de signal sur la base des paramètres d'atténuation.

2. Procédé selon la revendication 1, dans lequel l'un ou plusieurs seuils d'usure définissent au moins un domaine de surconsommation de budget, et dans lequel l'adaptation (118a, 118b) des paramètres d'atténuation de l'atténuateur de signal sur la base de la comparaison comprend l'adaptation des paramètres d'atténuation de l'atténuateur de signal pour réduire une probabilité de survenance d'événement d'usure si la métrique d'accumulation d'usure se trouve dans le domaine de surconsommation de budget.

3. Procédé selon l'une quelconque des revendications 1 et 2, dans lequel l'un ou plusieurs seuils d'usure définissent un domaine de sous-consommation de budget, et dans lequel l'adaptation (118a, 118b) des paramètres d'atténuation de l'atténuateur de signal sur la base de la comparaison comprend l'adaptation des paramètres d'atténuation de l'atténuateur de signal pour augmenter une probabilité de survenance d'événement d'usure si la métrique d'accumulation d'usure se trouve dans le domaine de sous-consommation de budget.

4. Procédé selon l'une quelconque des revendications 1 à 3, dans lequel l'un ou plusieurs seuils d'usure définissent un domaine de consommation de budget acceptable, et dans lequel le procédé comprend en outre le maintien des paramètres d'atténuation de l'atténuateur de signal si la métrique d'accumulation d'usure se trouve dans le domaine de consommation de budget acceptable.

5. Procédé selon l'une quelconque des revendications 1 à 4, dans lequel au moins l'une des deux unités de traitement de signal ou plus ayant un processus d'usure associé comprend une ou plusieurs de :
une pluralité des deux unités de traitement de signal ou plus ayant un processus d'usure associé respectif ; et
au moins l'une des deux unités de traitement de signal ou plus ayant une pluralité de processus d'usure associés respectifs,
dans lequel l'obtention (105a, 106b, 108b, 112b) de l'indication, la mise à jour (114a, 114b) de la métrique d'accumulation d'usure et la comparaison (116a, 116b) de celle-ci à un ou plusieurs seuils d'usure sont effectuées pour chacun des processus d'usure respectifs,
dans lequel l'un ou plusieurs seuils d'usure définissent au moins un domaine de surconsommation de budget du processus d'usure respectif, et
dans lequel l'adaptation (118a, 118b) des paramètres d'atténuation de l'atténuateur de signal sur la base de la comparaison comprend l'adaptation des paramètres d'atténuation de l'atténuateur de signal pour réduire une probabilité de survenance d'événement d'usure si la métrique d'accumulation d'usure d'au moins l'un des processus d'usure respectifs se trouve dans le domaine de surconsommation de budget respectif.

6. Procédé selon la revendication 5, dans lequel l'un ou plusieurs seuils d'usure définissent au moins un domaine de sous-consommation du processus d'usure respectif, et
dans lequel l'adaptation (118a, 118b) des paramètres d'atténuation de l'atténuateur de signal sur la base de la comparaison comprend l'adaptation des paramètres d'atténuation de l'atténuateur de signal pour augmenter la probabilité de survenance d'événement d'usure si la métrique d'accumulation d'usure de tous les processus d'usure se trouve dans le domaine de sous-consommation de budget respectif.

7. Procédé selon la revendication 6, comprenant en outre le maintien autrement des paramètres d'atténuation de l'atténuateur de signal.

8. Procédé selon l'une quelconque des revendications 1 à 4, dans lequel au moins l'une des deux unités de traitement de signal ou plus ayant un processus d'usure associé comprend une ou plusieurs de :
une pluralité des deux unités de traitement de signal ou plus ayant un processus d'usure associé respectif ; et
au moins l'une des deux unités de traitement de signal ou plus ayant une pluralité de processus d'usure associés respectifs,
dans lequel l'obtention (105a, 106b, 108b, 112b) de l'indication, la mise à jour (114a, 114b) de la métrique d'accumulation d'usure et la comparaison (116a, 116b) de celle-ci à un ou plusieurs seuils d'usure sont effectuées pour chacun des processus d'usure respectifs,
dans lequel l'un ou plusieurs seuils d'usure définissent au moins un domaine de surconsommation de budget du processus d'usure respectif, et
dans lequel l'adaptation (118a, 118b) des paramètres d'atténuation de l'atténuateur de signal sur la base de la comparaison comprend :
pour chacun des processus d'usure respectifs, la détermination de paramètres d'atténuation intermédiaires définissant une probabilité de survenance d'événement d'usure réduite si la métrique d'accumulation d'usure du processus d'usure se trouve dans le domaine de surconsommation de budget ; et
l'adaptation des paramètres d'atténuation sur la base d'une somme pondérée, pour les processus d'usure, des paramètres d'atténuation intermédiaires.

9. Procédé selon l'une quelconque des revendications 1 à 8, dans lequel les paramètres d'atténuation de l'atténuateur de signal comprennent un ou plusieurs de : une atténuation admissible maximale, une atténuation admissible minimale, une taille de pas d'augmentation d'atténuation, une taille de pas de réduction d'atténuation, une hystérèse de temps d'augmentation d'atténuation, une hystérèse de temps de réduction d'atténuation, un taux d'augmentation d'atténuation admissible maximale, un taux de réduction d'atténuation admissible maximale, une polarisation de seuil d'augmentation d'atténuation de la fonction de consommation moyenne de budget de détérioration pour fournir l'un des seuils de budget de détérioration, une polarisation de seuil de réduction d'atténuation de la fonction de consommation moyenne de budget de détérioration pour fournir l'un des seuils de budget de détérioration, et un ou plusieurs poids de paramètres d'atténuation.

10. Procédé selon l'une quelconque des revendications 1 à 9, dans lequel chacun de l'un ou plusieurs seuils d'usure est une fonction d'un âge actuel de la chaîne de traitement de signal, la fonction étant basée sur le budget d'usure et un temps d'usure cible du processus d'usure.

11. Procédé selon l'une quelconque des revendications 1 à 10, comprenant en outre le lancement de la métrique d'accumulation d'usure pour le budget d'usure, dans lequel la mise à jour de la métrique d'accumulation d'usure comprend la réduction de la métrique d'accumulation d'usure par le coût d'événement d'usure.

12. Produit de programme informatique comprenant un support lisible par ordinateur (300), sur lequel se trouve un programme informatique comprenant des instructions de programme, le programme informatique pouvant être chargé dans une unité de traitement de données (330) et étant apte à provoquer l'exécution du procédé selon l'une quelconque des revendications 1 à 11 lorsque le programme informatique est exécuté par l'unité de traitement de données.

13. Agencement de commande d'atténuateur d'une chaîne de traitement de signal comprenant deux unités de traitement de signal ou plus (220, 230, 240), l'une des deux unités de traitement de signal ou plus étant un atténuateur de signal (220), dans lequel au moins l'une des deux unités de traitement de signal ou plus a un processus d'usure associé et un budget d'usure correspondant, dans lequel un événement d'usure du processus d'usure survient lorsqu'un niveau d'un signal d'indication d'usure de la chaîne de traitement de signal se trouve dans une région d'usure, et dans lequel le processus d'usure est modélisé par un coût d'événement d'usure associé à un événement d'usure correspondant, l'agencement comprenant :
l'atténuateur de signal (220) apte à appliquer une atténuation de signal adaptative d'un signal d'entrée d'atténuateur sur la base d'un ou plusieurs paramètres d'atténuation pour fournir un signal de sortie d'atténuateur ; et
un organe de commande d'atténuation (250) apte à :
commander l'atténuateur de signal (220) sur la base des paramètres d'atténuation ;
obtenir une indication de survenance d'un événement d'usure du processus d'usure ; et
en réponse à l'indication obtenue indiquant qu'un événement d'usure du processus d'usure est survenu :
- la mise à jour d'une métrique d'accumulation d'usure du processus d'usure par le coût d'événement d'usure associé ;
- la comparaison de la métrique d'accumulation d'usure du processus d'usure à un ou plusieurs seuils d'usure du processus d'usure ; et
- l'adaptation des paramètres d'atténuation de l'atténuateur de signal sur la base de la comparaison.

14. Agencement selon la revendication 13, dans lequel l'organe de commande d'atténuation (250) comprend un organe de commande de gain automatique (252) et un administrateur de processus d'usure (254), et dans lequel :
l'organe de commande de gain automatique (252) est apte à :
commander l'atténuateur de signal sur la base des paramètres d'atténuation ;
obtenir l'indication de survenance d'un événement d'usure du processus d'usure ; et
fournir l'indication qu'un événement d'usure du processus d'usure est survenu à l'organe de commande de processus d'usure ; et
l'administrateur de processus d'usure (254) est apte à, en réponse à l'indication obtenue qu'un événement d'usure du processus d'usure est survenu :
mettre à jour la métrique d'accumulation d'usure du processus d'usure par le coût d'événement d'usure associé ;
comparer la métrique d'accumulation d'usure du processus d'usure à l'un ou plusieurs seuils d'usure du processus d'usure ;
adapter les paramètres d'atténuation de l'atténuateur de signal sur la base de la comparaison ; et
fournir les paramètres d'atténuation adaptés à l'organe de commande de gain automatique (252).

15. Agencement selon l'une quelconque des revendications 13 et 14, dans lequel les deux unités de traitement de signal ou plus (220, 230, 240) comprennent en outre un amplificateur (230) apte à recevoir le signal de sortie d'atténuateur en tant que signal d'entrée d'amplificateur, et dans lequel l'au moins une des deux unités de traitement de signal ou plus comprend un ou plusieurs de l'atténuateur de signal (220) et de l'amplificateur (230).

16. Appareil électronique comprenant l'agencement selon l'une quelconque des revendications 13 à 15.

17. Appareil électronique selon la revendication 16, dans lequel l'appareil électronique est un dispositif de communication sans fil, un modem de communication sans fil ou un récepteur de communication sans fil.
